# EUROPEAN PATENT SPECIFICATION

(11) **EP 4 341 030 B1**
(45) Date of publication and mention of the grant of the patent: **27.08.2025**
(21) Application number: 22731825.0
(22) Date of filing: 17.05.2022
(51) Int. Cl.: B23K 1/00, B23K 1/002, B23K 3/047, H05B 6/14, H05B 6/42, H10F 71/00, B23K 101/36

(54) **DEVICE FOR SOLDERING THE INTERCONNECTIONS OF PHOTOVOLTAIC PANELS WITH AN INDUCTOR AND LONGITUDINALLY ARRANGED INSERT**
VORRICHTUNG FÜR DAS LÖTEN DER VERBINDUNGEN VON PHOTOVOLTAIKPANEELEN MIT EINER INDUKTIVITÄT UND EINEM LÄNGSANGEORDNETEN EINLAGE
DISPOSITIF DE BRASAGE D'INTERCONNEXIONS DE PANNEAUX PHOTOVOLTAÏQUES AVEC UNE BOBINE D'INDUCTION ETUN INSERT DISPOSÉ LONGITUDINALEMENT

(30) Priority: 18.05.2021 IT 202100012740
(43) Date of publication of application: 27.03.2024
(73) Proprietor: Ecoprogetti S.R.L., 35010 Carmignano di Brenta (PD) (IT)
(72) Inventor: SARTORE, Domenico, 35010 CARMIGNANO DI BRENTA (PD) (IT); GONZATO, Eugenio, 35010 CARMIGNANO DI BRENTA (PD) (IT)
(74) Representative: Petraz, Davide Luigi
(86) International application number: PCT/IT2022/050129
(87) International publication number: WO 2022/244025

(56) References cited:
- US-A1- 2005 199 615
- US-A1- 2009 236 328
- US-A1- 2012 031 895

## Description

The present invention concerns a device for soldering the interconnections of photovoltaic panels, see claim 1.

The invention is applicable in the industrial field, in particular in the sector of the production of photovoltaic panels.

US 2012/031895 A1 (describing the preamble of claim 1) and US 2009/0236328 disclose examples of devices for induction soldering a strip on a solar cell.

Photovoltaic panels generally comprise a plurality of cells (usually sixty or seventy-two), which are connected to each other through the use of first ribbon filaments, constituting bus bars, which are in turn soldered to second ribbon filaments, called "header" ribbons, orthogonal to the former and usually wider than them.

To connect the bus bars to the header ribbons, a soldering is normally carried out between them, melting the tin that covers the header ribbon after positioning the latter on the ribbons of the bus bar.

Usually, the soldering is carried out using numerical control equipment equipped with induction or laser soldering devices, which carry out a punctual soldering by melting the header ribbon in correspondence with each single bus bar ribbon, creating the joint once solidification has occurred.

The state of the art has some disadvantages.

Normally, the device for such solders has:
- either a terminal with a single induction point that moves along the header ribbon, between the successive bus bars, with a pitch corresponding to the distance between them; however, this determines a long and uncomfortable production method and the need to reprogram the pitch in the event of a variation in panel format and therefore in the distance between the bus bars,
- or a terminal with a plurality of induction points, generally between five and ten, positioned at a distance corresponding to the distance between the bus bars, which moves step-wise between successive groups of bus bars; however, this determines the need to replace the terminal in the event of a variation in the format of the panel to be made, and therefore in the distance between the bus bars, with a consequent reduction in production due to the downtimes necessary for the replacement of the terminal and the reprogramming of the equipment,
- or a terminal equipped with a laser source directed toward the point of intersection between the header ribbon and a bus bar ribbon, which moves along the header ribbon, between the successive bus bars, with a pitch corresponding to the distance between them; however, this determines a long and uncomfortable production method and the need to reprogram the pitch in the event of a variation in the panel format and therefore in the distance between the bus bars.

The aim of the present invention is to provide a device for soldering the interconnections of photovoltaic panels which is able to improve the state of the art in one or more of the aspects indicated above.

Within this aim, one purpose of the invention is to provide a device for soldering the interconnections of photovoltaic panels which can be used for any format of photovoltaic panel whatsoever, and which allows soldering for any format of photovoltaic panel whatsoever, regardless of the distance between the bus bars.

Another purpose of the invention is to provide a device for soldering the interconnections of photovoltaic panels which does not require the need to replace the terminal in the event of a variation in the format of the panel to be made, simultaneously increasing the productivity of the equipment with which it is associated, given the same time, compared to similar devices of a known type.

Furthermore, the present invention aims to overcome the disadvantages of the state of the art in an alternative way to possible existing solutions.

Not the last purpose of the invention is to provide a device for soldering the interconnections of photovoltaic panels which is highly reliable, relatively easy to manufacture and at competitive costs.

This task, as well as these and other purposes that will be clearer below, are achieved by a device for soldering the interconnections of photovoltaic panels as defined in claim 1, comprising:
- an inductor, which in turn comprises a filament, which substantially develops so as to form two parallel branches: a first branch and a second branch,
- an insert, which has a longitudinal development, which is at least partly surrounded longitudinally by the filament and is interposed between the two branches.

Further preferred embodiments of the present invention are defined in the dependent claims.

Other characteristics and advantages of the invention will become more apparent from the description of a preferred but not exclusive embodiment of the device for soldering the interconnections of photovoltaic panels according to the invention, which is shown, by way of a non-limiting example, in the attached drawings, wherein:

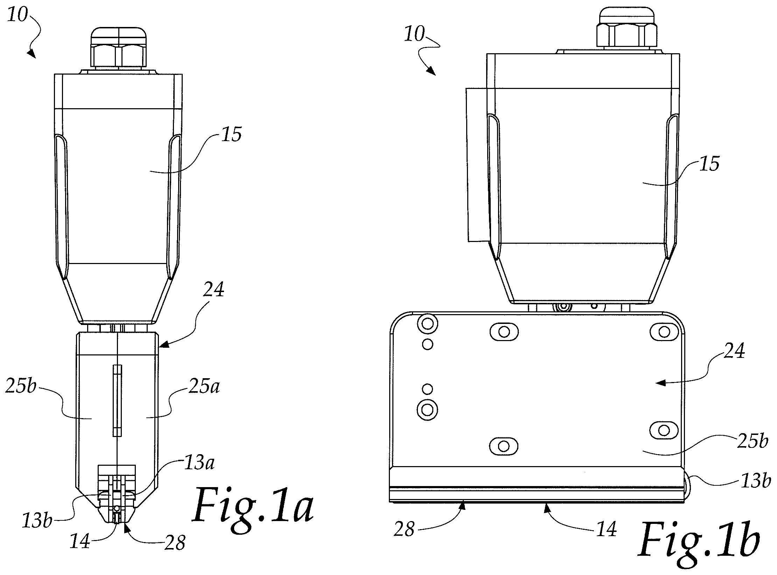

- figs. 1a and 1b each show a different view of a device for soldering the interconnections of photovoltaic panels according to the invention;

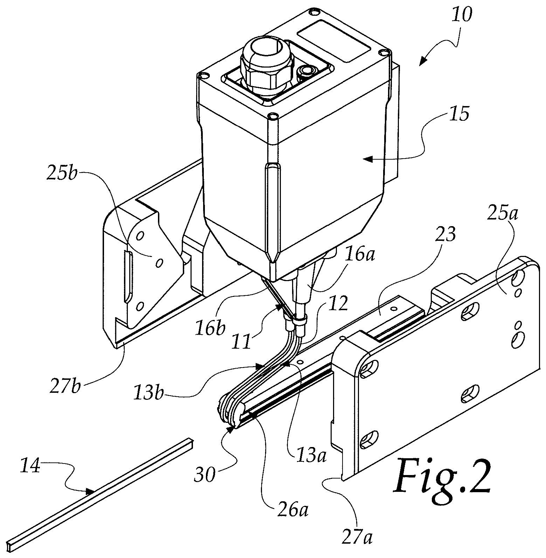

- fig. 2 shows an exploded view of the device of figs. 1a and 1b;

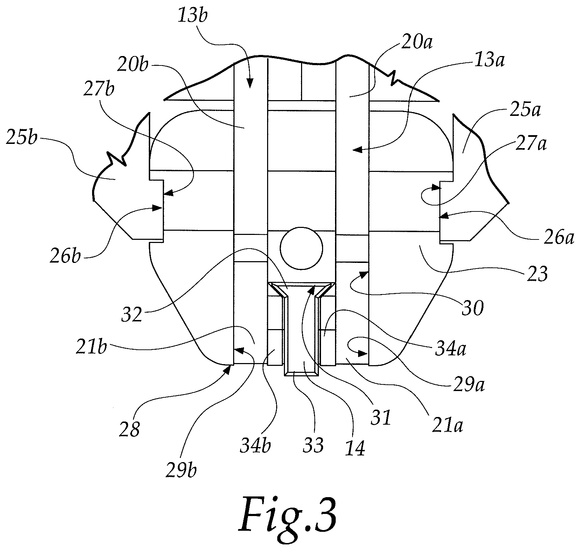

- fig. 3 shows an enlarged portion of the device of fig. 1a;
- fig. 4 shows the internal components of the device for soldering the interconnections of photovoltaic panels according to the invention;
- fig. 5 shows a perspective view of an application of use of the device for soldering the interconnections of photovoltaic panels according to the invention.

With reference to the drawings above, a device for soldering the interconnections of photovoltaic panels, according to the invention, is indicated as a whole with reference number 10.

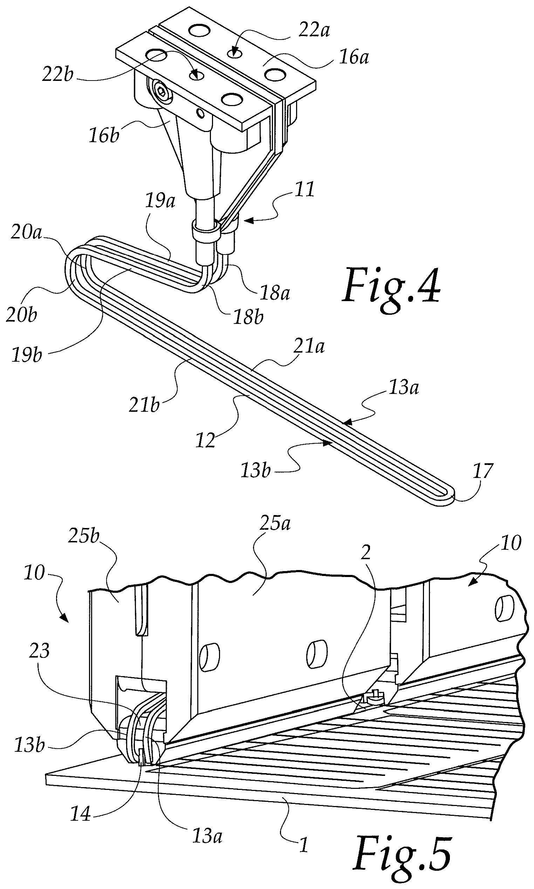

With particular reference to fig. 5, the device 10 operates on a photovoltaic panel 1, heating the header ribbon 2.

Advantageously, the soldering equipment comprises a plurality of aligned devices 10.

The device 10 comprises:
- an inductor 11, which in turn comprises a filament 12, which substantially develops so as to form two parallel branches 13a, 13b: a first branch 13a and a second branch 13b,
- an insert 14, which has a longitudinal development, which is at least partly surrounded longitudinally by the filament 12 and is interposed between the two branches 13a, 13b of the latter.

In practice, the filament 12 almost completely surrounds the insert 14 in its longitudinal direction, on a plane parallel to the lying plane of the photovoltaic panel 1.

In particular, the insert 14 is made of glass-ceramics material, preferably the one known by the trade name of "Macor" of the US company Corning Inc.

The inductor 11 develops from a heating head 15 of a per se known type.

The inductor 11 comprises a pair of electrodes 16a, 16b.

Each branch 13a, 13b of the filament 12 develops starting from a respective one of the electrodes 16a, 16b toward a U-shaped reciprocal connection portion 17.

In particular, each branch 13a, 13b of the filament 12 comprises between the respective electrode 16a, 16b and the connection portion 17, in the following order:
- an arc-like segment 18a, 18b, for connection to the electrode 16a, 16b,
- a first substantially rectilinear segment 19a, 19b,
- a substantially U-shaped curvilinear segment 20a, 20b,
- a second substantially rectilinear segment 21a, 21b, parallel to the first substantially rectilinear segment 19a, 19b.

The lying plane of the first branch 13a of the filament 12 is parallel to the lying plane of the second branch 13b of the filament 12.

Specifically, the second substantially rectilinear segment 21a, 21b is parallel to the first substantially rectilinear segment 19a, 19b, but has a greater extension than it.

Furthermore:
- the second substantially rectilinear segment 21a of the first branch 13a is parallel to the second substantially rectilinear segment 21b of the second branch 13b,
- the first substantially rectilinear segment 19a of the first branch 13a is parallel to the first substantially rectilinear segment 19b of the second branch 13b.

The filament 12 is advantageously made of copper and has a tubular section with a square contour for the flow of cooling water.

The electrodes 16a, 16b have a substantially triangular profile and are symmetrical with respect to the plane of symmetry of the device 10 that is parallel to the lying plane of a branch 13a, 13b of the filament 12.

Each electrode 16a, 16b has a duct 22a, 22b for the flow of cooling water, which is in fluidic connection with the respective branch 13a, 13b of the filament 12.

The device 10 comprises a support 23 of the insert 14, which has a longitudinal development and an extension that is substantially equal to the extension of the latter and of the second substantially rectilinear segment 21a, 21b of the branches 13a, 13b of the filament 12.

The support 23 is interposed between the first substantially rectilinear segment 19a, 19b and the second substantially rectilinear segment 21a, 21b of the branches 13a, 13b of the filament 12.

The inductor 11 is contained, at least partly, in a substantially flat shell 24 consisting of two half-shells 25a, 25b, which are symmetrical with respect to the plane of symmetry of the device 10 which is parallel to the lying plane of a branch 13a, 13b of the filament 12.

The half-shells are respectively:
- a first half-shell 25a, which is substantially parallel to the lying plane of the first branch 13a of the filament 12, and is proximate to the first branch 13a,
- a second half-shell 25b, which is substantially parallel to the lying plane of the second branch 13b of the filament 12, and is proximate to the second branch 13b.

In particular, the support 23 has two opposite lateral grooves 26a, 26b with a longitudinal development, for the same shape coupling to a corresponding relief 27a, 27b of the half-shell 25a, 25b, respectively:
- a first lateral groove 26a, parallel to the lying plane of the first branch 13a of the filament 12, for the same shape coupling to a relief 27a of the first half-shell 25a,
- a second lateral groove 26b, parallel to the lying plane of the second branch 13b of the filament 12, for the same shape coupling to a relief 27b of the second half-shell 25b.

Each half-shell 25a, 25b is complementary and counter-contoured to the corresponding:
- electrode 16a, 16b,
- branch 13a, 13b of the filament 12,
- lateral groove 26a, 26b of the support 23.

The support 23 is at least partly protruding from the shell 24 and has a face 28 protruding from the shell 24, able to be facing and substantially parallel to the panel 1, during the operating phase of the device 10.

The support 23 has, on the face 28, a seating 30 with a longitudinal development, which is defined by two opposite walls 29a, 29b that are reciprocally parallel and orthogonal to the lying plane of the face 28.

The following are inserted in the seating 30:
- the second substantially rectilinear segment 21a, 21b of the branch 13a, 13b of the filament 12, in contact with a corresponding one of the walls 29a, 29b so that it is contained within the overall size of the support 23 and does not protrude from the face 28,
- the insert 14, so that it partly protrudes from the support 23 beyond the face 28 thereof.

In particular, the seating 30 of the support 23 has a housing 31 for the insert 14, which is contoured for the same shape coupling to a first end portion 32 of the insert 14, opposite to a second end portion 33 able to contact the header ribbon 2.

The housing 31 is interposed between the first branch 13a and the second branch 13b of the filament 12.

Specifically, the insert 14 has a substantially T-shaped section, with:
- the first end portion 32, widened, corresponding to the wing of the T-shaped section,
- the second end portion 33, corresponding to the base of the core of the T-shaped section, which is protruding from the face 28 of the support 23.

Between the insert 14 and the branches 13a, 13b of the filament 12, the support 23 comprises two longitudinal appendices, respectively:
- a first longitudinal appendix 34a between the core of the T-shaped section of the insert 14 and the second substantially rectilinear segment 21a of the first branch 13a,
- a second longitudinal appendix 34b between the core of the T-shaped section of the insert 14 and the second substantially rectilinear segment 21b of the second branch 13b.

Specifically, the insert 14 protrudes by approximately 0.7 mm from the support 23 and this allows to prevent a direct contact between the filament 12 and the header ribbon 2 during the soldering phase, which could cause a short circuit of the solder.

The support 23 is made of plastic material such as, for example, polyoxymethylene (POM).

The operation of the device 10 according to the invention is as follows.

To proceed with the soldering between the header ribbon 2 and the bus bar ribbons (not shown in the drawings) of panel 1:
- the device 10 is moved toward the panel 1, putting the insert 14 in contact, for a few seconds, with the header ribbon 2, previously positioned in contact with the bus bar ribbons,
- while the insert 14 presses the header ribbon 2, keeping said header ribbon 2 in contact with the bus bar ribbons for its entire length, an electric current is made to flow along the filament 12, generating a magnetic field between the two branches 13a, 13b, which heats and melts the tin that covers the header ribbon 2,
- at the same time, cold water is made to flow inside the filament 12, through the ducts 22a, 22b, in order to cool the branches 13a, 13b of the filament 12,
- due to the melting and crushing of the tin that covers the header ribbon 2 onto the bus bar ribbons, the first ribbon binds to the latter, creating, once solidification has occurred, the connection joints in correspondence with the reciprocal intersection points.

It should be noted that a similar device allows to heat the header ribbon homogeneously for the entire length of the insert, regardless of where the bus bar ribbons are positioned, and this makes the device according to the invention able to be used for any format whatsoever of photovoltaic panel.

In practice, it has been found that the invention achieves the intended aim and purposes, providing a device for soldering the interconnections of photovoltaic panels which can be used for any format whatsoever of photovoltaic panel and allows soldering for any format whatsoever of photovoltaic panel, regardless of the distance between the bus bars.

With the invention, we have perfected a device for soldering the interconnections of photovoltaic panels which does not require the need to replace the terminal in the event of a change in format of the panel to be produced, simultaneously increasing the productivity of the equipment with which it is associated, for the same amount of time, compared to similar devices of a known type.

The invention thus conceived is susceptible to numerous modifications and variations, all of which are within the scope of the present invention as defined in the appended claims.

In practice, any materials, as well as contingent shapes and sizes, can be used according to requirements and to the state of the art, as long as they are compatible with the specific use.

## Claims

1. A device (10) for soldering the interconnections of photovoltaic panels (1), soldering a header ribbon (2) and bus bar ribbons, comprising:
- an inductor (11), which in turn comprises a filament (12) along which an electric current is made to flow, which substantially develops so as to form two parallel branches (13a, 13b): a first branch (13a) and a second branch (13b) between which a magnetic field is generated,
**characterized by**
- an insert (14), which has a longitudinal development, which is at least partly surrounded longitudinally by said filament (12) and is interposed between said two branches (13a, 13b), said insert (14) being configured to press the header ribbon (2), so as to keep in use said header ribbon (2) in contact with the bus bar ribbons for its entire length.

2. The device (10) according to claim 1, **characterized in that** said insert (14) is made of glass-ceramics material.

3. The device (10) according to any of the preceding claims, **characterized in that** said inductor (11) comprises a pair of electrodes (16a, 16b), each one of said branches (13a, 13b) of said filament (12) developing starting from a respective one of said electrodes (16a, 16b) toward a U-shaped reciprocal connection portion (17).

4. The device (10) according to any of the preceding claims, **characterized in that** each one of said branches (13a, 13b) of said filament (12) comprises, between the respective one of said electrodes (16a, 16b) and said reciprocal connection portion (17), in the following order:
- an arc-like segment (18a, 18b) for connection to the respective one of said electrodes (16a, 16b),
- a first substantially rectilinear segment (19a, 19b),
- a substantially U-shaped curvilinear segment (20a, 20b),
- a second substantially rectilinear segment (21a, 21b), which is parallel to said first substantially rectilinear segment (19a, 19b).

5. The device (10) according to any of the preceding claims, **characterized in that** the lying plane of said first branch (13a) of said filament (12) is parallel to the lying plane of said second branch (13b) of said filament (12), said second substantially rectilinear segment (21a, 21b) being parallel to said first substantially rectilinear segment (19a, 19b) and having a larger extension than the latter.

6. The device (10) according to any of the preceding claims, **characterized in that** said filament (12) is made of copper and has a tubular section with a square contour.

7. The device (10) according to any of the preceding claims, **characterized in that** said electrodes (16a, 16b) are symmetrical with respect to the plane of symmetry of said device (10) that is parallel to the lying plane of one of said branches (13a, 13b) of said filament (12), each one of said electrodes (16a, 16b) having a duct (22a, 22b) in fluidic connection with the respective one of said branches (13a, 13b) of said filament (12).

8. The device (10) according to any of the preceding claims, **characterized in that** it comprises a support (23) of said insert (14) which has a longitudinal development and an extension that is substantially equal to the extension of the latter and of said second substantially rectilinear segment (21a, 21b) of said branches (13a, 13b) of said filament (12), said support (23) being interposed between said first substantially rectilinear segment (19a, 19b) and said second substantially rectilinear segment (21a, 21b) of said branches (13a, 13b) of said filament (12).

9. The device (10) according to any of the preceding claims, **characterized in that** said inductor (11) is contained at least partly in a substantially flat shell (24), consisting of two half shells (25a, 25b) which are symmetrical with respect to the plane of symmetry of said device (10) that is parallel to the lying plane of one of said branches (13a, 13b) of said filament (12), said half shells (25a, 25b) being respectively:
- a first half shell (25a), which is substantially parallel to the lying plane of said first branch (13a) of said filament (12) and is proximate to said first branch (13a),
- a second half shell (25b), which is substantially parallel to the lying plane of said second branch (13b) of said filament (12) and is proximate to said second branch (13b).

10. The device (10) according to any of the preceding claims, **characterized in that** said support (23) has two opposite lateral grooves (26a, 26b) with a longitudinal development, for the same shape coupling to a corresponding relief (27a, 27b) of one of said half shells (25a, 25b), respectively:
- a first lateral groove (26a), which is parallel to the lying plane of said first branch (13a) of said filament (12) for the same shape coupling to a relief (27a) of said first half shell (25a),
- a second lateral groove (26b), which is parallel to the lying plane of said second branch (13b) of said filament (12) for the same shape coupling to a relief (27b) of said second half shell (25b), each one of said half shells (25a, 25b) being complementary and counter-contoured to the corresponding ones of:
- said electrodes (16a, 16b),
- said branches (13a, 13b) of said filament (12),
- said lateral grooves (26a, 26b) of said support (23).

11. The device (10) according to any of the preceding claims, **characterized in that** said support (23) is at least partly protruding from said shell (24) and has a face (28) that protrudes from said shell (24) which is able to be facing and substantially parallel to a photovoltaic panel (1) in the operating phase of said device (10).

12. The device (10) according to claim 11, **characterized in that** said support (23) has, on said face (28), a seating (30) with a longitudinal development, which is defined by two reciprocally parallel opposite walls (29a, 29b) which are orthogonal to the lying plane of said face (28), the following being inserted in said seating (30):
- said second substantially rectilinear segment (21a, 21b) of said branches (13a, 13b) of said filament (12), in contact with a corresponding one of said walls (29a, 29b), so that it is contained within the overall size of said support (23) and does not protrude from said face (28),
- said insert (14), so that it protrudes at least partly from said support (23) beyond said face (28).

13. The device (10) according to any of the preceding claims, **characterized in that** said seating (30) of the support (23) has a housing (31) for said insert (14) that is contoured for the same shape coupling to a first end portion (32) of said insert (14) that is opposite to a second end portion (33) able to contact a header ribbon (2) of a photovoltaic panel (1), said housing (31) being interposed between said first branch (13a) and said second branch (13b) of said filament (12).

14. The device (10) according to any of the preceding claims, **characterized in that** said insert (14) has a substantially T-shaped section, with:
- said first end portion (32), widened, which corresponds to the wing of said T-shaped section,
- said second end portion (33), which corresponds to the base of the core of said T-shaped section, which is protruding from said face (28) of said support (23).

15. The device (10) according to any of the preceding claims, **characterized in that** between said insert (14) and said branches (13a, 13b) of said filament (12), said support (23) comprises two longitudinal appendices, respectively:
- a first longitudinal appendix (34a) between said core of said T-shaped section of said insert (14) and said second substantially rectilinear segment (21a) of said first branch (13a),
- a second longitudinal appendix (34b) between said core of said T-shaped section of said insert (14) and said second substantially rectilinear segment (21b) of said second branch (13b).

## Patentansprüche

1. Vorrichtung (10) zum Löten der Verschaltung von Photovoltaikmodulen (1), die ein Steckverbinder-Flachbandkabel (2) und ein Sammelschienen-Verbindungskabel lötet, umfassend:
- einen Induktor (11), der wiederum einen Spulendraht (12) umfasst, entlang dessen ein elektrischer Strom fließen gelassen wird, der im Wesentlichen so ausgerichtet ist, dass er zwei Parallelzweige (13a, 13b) bildet: einen ersten Zweig (13a) und einen zweiten Zweig (13b) zwischen denen ein Magnetfeld generiert wird,
**gekennzeichnet durch,**
- einen Einsatz (14), der eine längs gerichtete Ausrichtung hat, in Längsrichtung mindestens teilweise von dem Spulendraht (12) umgeben ist und zwischen den beiden Zweigen (13a, 13b) angeordnet ist, wobei der Einsatz (14) so konfiguriert ist, das Steckverbinder-Flachbandkabel (2) anzudrücken, um das Steckverbinder-Flachbandkabel (2) über die gesamte Länge in Kontakt mit dem Sammelschienen-Verbindungskabel zu halten.

2. Vorrichtung (10) nach Anspruch 1, **dadurch gekennzeichnet, dass** der Einsatz (14) aus einem Glaskeramikwerkstoff besteht.

3. Vorrichtung (10) nach einem der vorherigen Ansprüche, **dadurch gekennzeichnet, dass** der Induktor (11) ein Elektrodenpaar (16a, 16b) umfasst, wobei jeder der Zweige (13a, 13b) des Spulendrahts (12) startend von einer jeweiligen der Elektroden (16a, 16b) in Richtung eines U-förmigen Umkehrverbindungsabschnitts (17) ausgerichtet ist.

4. Vorrichtung (10) nach einem der vorherigen Ansprüche, **dadurch gekennzeichnet, dass** jeder der Zweige (13a, 13b) des Spulendrahts (12), zwischen den entsprechenden Elektroden (16a, 16b) und dem U-förmigen Umkehrverbindungsabschnitts (17), in der folgenden Reihenfolge folgendes aufweist:
- ein bogenartiges Segment (18a, 18b) für die Verbindung mit der jeweiligen einen der Elektroden (16a, 16b),
- ein erstes im Wesentlichen geradliniges Segment (19a, 19b),
- ein im Wesentlichen U-förmiges kurvenförmiges Segment (20a, 20b),
- ein zweites im Wesentlichen geradliniges Segment (21a, 21b), das parallel zum ersten im Wesentlichen geradlinigen Segment (19a, 19b) ist.

5. Vorrichtung (10) nach einem der vorherigen Ansprüche, **dadurch gekennzeichnet, dass** die Lageebene des ersten Zweigs (13a) des Spulendrahts (12) parallel zu der Lageebene des zweiten Zweigs (13b) des Spulendrahts (12) ist, wobei das zweite im Wesentlichen geradlinige Segment (21a, 21b) parallel zum ersten wesentlich geradlinigen Segment (19a, 19b) ist und eine größere Erstreckung als das letztere aufweist.

6. Vorrichtung (10) nach einem der vorherigen Ansprüche, **dadurch gekennzeichnet, dass** der Spulendraht (12) aus Kupfer gefertigt ist und einen rohrförmigen Abschnitt mit einer quadratischen Kontur aufweist.

7. Vorrichtung (10) nach einem der vorherigen Ansprüche, **dadurch gekennzeichnet, dass** die Elektroden (16a, 16b) symmetrisch sind in Bezug auf die Symmetrieebene der Vorrichtung (10), die parallel zu der Lageebene einer der Zweige (13a, 13b) des Spulendrahts (12) ist, wobei jede der Elektroden (16a, 16b) einen Kanal (22a, 22b) aufweist, der mit dem jeweiligen einem der Zweige (13a, 13b) des Spulendrahts (12) in einer fluiden Verbindung ist.

8. Vorrichtung (10) nach einem der vorherigen Ansprüche, **dadurch gekennzeichnet, dass** sie eine Stütze (23) des Einsatzes (14) umfasst, die eine längs gerichtete Ausrichtung aufweist und eine Erstreckung, die im Wesentlich gleich ist zu der Erstreckung der letzteren und von dem zweiten im Wesentlichen gradlinigen Segment (21a, 21b) des Zweigs (13a, 13b) des Spulendrahts (12), der Einsatz (23) ist angeordnet zwischen dem ersten im Wesentlichen gradlinigen Segment (19a, 19b) und dem im Wesentlichen zweiten gradlinigen Segment (21a, 21b) des Zweigs (13a, 13b) des Spulendrahts (12).

9. Vorrichtung (10) nach einem der vorherigen Ansprüche, **dadurch gekennzeichnet, dass** der Induktor (11) mindestens teilweise in einem im Wesentlichen flachen Gehäuse (24) enthalten ist, das aus zwei halben Gehäusen (25a, 25b) besteht, die symmetrisch in Bezug zur Symmetrieebene der Vorrichtung (10) sind, die parallel zu der Lageebene eines der Zweige (13a, 13b) des Spulendrahts (12) ist, wobei die halben Gehäuse (25a, 25b) jeweils:
- ein erstes halbes Gehäuse (25a), das im Wesentlichen parallel zu der Lageebene des ersten Zweigs (13a) des Spulendrahts (12) ist und an den ersten Zweig (13a) grenzt,
- ein zweites halbes Gehäuse (25b) sind, das im Wesentlichen parallel zu der Lageebene des zweiten Zweigs (13b) des Spulendrahts (12) ist und an den zweiten Zweig (13b) grenzt.

10. Vorrichtung (10) nach einem der vorherigen Ansprüche, **dadurch gekennzeichnet, dass** der Einsatz (23) zwei gegenüberliegende Nuten (26a, 26b) mit einer längs gerichteten Ausrichtung aufweist, jeweils für eine formschlüssige Kupplung an ein entsprechendes Relief (27a, 27b) eines der halben Gehäuse (25a, 25b):
- eine erste seitliche Nut (26a), die parallel zur Lageebene des ersten Zweigs (13a) des Spulendrahts (12) ist, für die formschlüssige Kupplung an ein Relief (27a) des halben Gehäuses (25a),
- eine zweite seitliche Nut (26b), die parallel zu der Lageebene des zweiten Zweigs (13b) des Spulendrahts (12) ist, für die formschlüssige Kupplung an ein Relief (27b) des halben Gehäuses (25b), wobei jedes der halben Gehäuse (25a, 25b) komplementär und gegenkonturiert zu den entsprechenden von:
- den Elektroden (16a, 16b),
- den Zweigen (13a, 13b) des Spulendrahts (12),
- den seitlichen Nuten (26a, 26b) der Stütze (23) ist.

11. Vorrichtung (10) nach einem der vorherigen Ansprüche, **dadurch gekennzeichnet, dass** der Einsatz (23) wenigstens teilweise von dem Gehäuse (24) vorsteht und eine Fläche (28) aufweist, die von dem Gehäuse (24) vorsteht, das in der Betriebsphase der Vorrichtung (10) zu einem Photovoltaikmodul (1) gerichtet und im Wesentlichen parallel zu diesem ausgerichtet werden kann.

12. Vorrichtung (10) nach Anspruch 11, **dadurch gekennzeichnet, dass**
der Einsatz (23) auf der Fläche (28) einen Sitz (30) mit einer längs gerichteten Ausrichtung aufweist, der von zwei reziproken, parallelen, gegenüberliegenden Wänden (29a, 29b) definiert ist, die orthogonal zu der Lageebene der Fläche (28) sind, wobei folgendes in den Sitz (30) eingesetzt ist:
- das zweite im Wesentlichen gradlinige Segment (21a, 21b) der Zweige (13a, 13b) des Spulendrahts (12), in Kontakt mit einem der entsprechenden Wände (29a, 29b), sodass es innerhalb der Gesamtgröße der Stütze (23) enthalten ist und von der Fläche (28) nicht vorsteht,
- der Einsatz (14), sodass er wenigstens teilweise von der Stütze (23) jenseits der Fläche (28) vorsteht.

13. Vorrichtung (10) nach einem der vorherigen Ansprüche, **dadurch gekennzeichnet, dass** der Sitz (30) der Stütze (23) ein Gehäuse (31) für den Einsatz (14) aufweist, das für die formschlüssige Kupplung zu einem ersten Endteil (32) des Einsatzes (14) ausgebildet ist, das gegenüber eines zweiten Endteils (33) in der Lage ist, das Steckverbinder-Flachbandkabel (2) eines Photovoltaikmoduls (1) zu kontaktieren, wobei dieses Gehäuse (31) zwischen dem ersten Zweig (13a) und dem zweiten Zweig (13b) des Spulendrahts (12) angeordnet ist.

14. Vorrichtung (10) nach einem der vorherigen Ansprüche, **dadurch gekennzeichnet, dass** der Einsatz (14) ein im Wesentlichen T-förmigen Bereich aufweist, mit:
- dem ersten Endabschnitt (32), geweitet, das dem Flügel des T-förmigen Bereich entspricht,
- dem zweiten Endabschnitt (33), das der Basis des Kernes des T-förmigen Bereich entspricht, das von der Fläche (28) der Stütze (23) vorsteht.

15. Vorrichtung (10) nach einem der vorherigen Ansprüche, **dadurch gekennzeichnet, dass** die Stütze (23) zwischen dem Einsatz (14) und den Zweigen (13a, 13b) des Spulendrahts (12), zwei Längsfortsätze aufweist, entsprechend:
- einen ersten Längsfortsatz (34a) zwischen dem Kern des T-förmigen Bereich des Einsatzes (14) und dem zweiten im Wesentlichen gradlinigen Segment (21a) des ersten Zweigs (13a),
- einen zweiten Längsfortsatz (34b) zwischen dem Kern des T-förmigen Abschnittes des Einsatzes (14) und dem zweiten im Wesentlichen gradlinigen Segment (21b) des zweiten Zweigs (13b).

## Revendications

1. Dispositif (10) pour souder les interconnexions de panneaux photovoltaïques (1), souder un ruban de collecteur (2) et des rubans de barre omnibus, comprenant :
- une inductance (11), qui comprend à son tour un filament (12) le long duquel un courant électrique est amené à circuler, qui se développe sensiblement de manière à former deux branches parallèles (13a, 13b): une première branche (13a) et une seconde branche (13b) entre lesquelles un champ magnétique est généré,
**caractérisé par** :
- un insert (14), qui présente un développement longitudinal, qui est au moins partiellement entouré longitudinalement par ledit filament (12) et est interposé entre lesdites deux branches (13a, 13b), ledit insert (14) étant configuré pour presser le ruban de tête (2), de manière à maintenir en utilisation ledit ruban de tête (2) en contact avec les rubans de barre omnibus sur toute sa longueur.

2. Dispositif (10) selon la revendication 1, **caractérisé en ce que** ledit insert (14) est en matériau vitrocéramique.

3. Dispositif (10) selon l'une quelconque des revendications précédentes, **caractérisé en ce que** ladite inductance (11) comprend une paire d'électrodes (16a, 16b), chacune desdites branches (13a, 13b) dudit filament (12) se développant à partir d'une certaine respective desdites électrodes (16a, 16b) vers une partie de connexion réciproque en forme de U (17).

4. Dispositif (10) selon l'une quelconque des revendications précédentes, **caractérisé en ce que** chacune desdites branches (13a, 13b) dudit filament (12) comprend, entre la certaine respective desdites électrodes (16a, 16b) et ladite partie de connexion réciproque (17), dans l'ordre suivant :
- un segment en forme d'arc (18a, 18b) pour une connexion à la certaine respective desdites électrodes (16a, 16b),
- un premier segment sensiblement rectiligne (19a, 19b),
- un segment curviligne (20a, 20b) sensiblement en forme de U,
- un second segment sensiblement rectiligne (21a, 21b), qui est parallèle audit premier segment sensiblement rectiligne (19a, 19b).

5. Dispositif (10) selon l'une quelconque des revendications précédentes, **caractérisé en ce que** le plan de couchage de ladite première branche (13a) dudit filament (12) est parallèle au plan de couchage de ladite seconde branche (13b) dudit filament (12), ledit second segment sensiblement rectiligne (21a, 21b) étant parallèle audit premier segment sensiblement rectiligne (19a, 19b) et présentant une extension plus grande que ce dernier.

6. Dispositif (10) selon l'une quelconque des revendications précédentes, **caractérisé en ce que** ledit filament (12) est réalisé en cuivre et présente une section tubulaire avec un contour carré.

7. Dispositif (10) selon l'une quelconque des revendications précédentes, **caractérisé en ce que** lesdites électrodes (16a, 16b) sont symétriques par rapport au plan de symétrie dudit dispositif (10) qui est parallèle au plan de couchage d'une certaine desdites branches (13a, 13b) dudit filament (12), chacune desdites électrodes (16a, 16b) présentant un conduit (22a, 22b) en connexion fluidique avec la certaine respective desdites branches (13a, 13b) dudit filament (12).

8. Dispositif (10) selon l'une quelconque des revendications précédentes, **caractérisé en ce qu'**il comprend un support (23) dudit insert (14) qui présente un développement longitudinal et une extension qui est sensiblement égale à l'extension de ce dernier et dudit second segment sensiblement rectiligne (21a, 21b) desdites branches (13a, 13b) dudit filament (12), ledit support (23) étant interposé entre ledit premier segment sensiblement rectiligne (19a, 19b) et ledit second segment sensiblement rectiligne (21a, 21b) desdites branches (13a, 13b) dudit filament (12).

9. Dispositif (10) selon l'une quelconque des revendications précédentes, **caractérisé en ce que** ladite inductance (11) est contenue au moins en partie dans une enveloppe sensiblement plate (24), constituée de deux demi-enveloppes (25a, 25b) qui sont symétriques par rapport au plan de symétrie dudit dispositif (10) qui est parallèle au plan couché d'une certaine desdites branches (13a, 13b) dudit filament (12), lesdites demi-enveloppes (25a, 25b) étant respectivement :
- une première demi-enveloppe (25a), qui est sensiblement parallèle au plan de couchage de ladite première branche (13a) dudit filament (12) et est proche de ladite première branche (13a),
- une seconde demi-enveloppe (25b), qui est sensiblement parallèle au plan de couchage de ladite seconde branche (13b) dudit filament (12) et est proche de ladite seconde branche (13b).

10. Dispositif (10) selon l'une quelconque des revendications précédentes, **caractérisé en ce que** ledit support (23) a deux rainures latérales opposées (26a, 26b) avec un développement longitudinal, pour un couplage de même forme à un relief correspondant (27a, 27b) d'une certaine desdites demi-enveloppes (25a, 25b), respectivement :
- une première rainure latérale (26a), qui est parallèle au plan de couchage de ladite première branche (13a) dudit filament (12) pour un couplage de même forme à un relief (27a) de ladite première demi-enveloppe (25a),
- une seconde rainure latérale (26b), qui est parallèle au plan de couchage de ladite seconde branche (13b) dudit filament (12) pour un couplage de même forme à un relief (27b) de ladite seconde demi-enveloppe (25b), chacune desdites demi-enveloppes (25a, 25b) étant complémentaire et d'un profil homologue aux certaines correspondantes parmi :
- lesdites électrodes (16a, 16b),
- lesdites branches (13a, 13b) dudit filament (12),
- lesdites rainures latérales (26a, 26b) dudit support (23).

11. Dispositif (10) selon l'une quelconque des revendications précédentes, **caractérisé en ce que** ledit support (23) fait au moins partiellement saillie à partir de ladite enveloppe (24) et présente une face (28) qui fait saillie à partir de ladite enveloppe (24) qui peut être en regard et sensiblement parallèle à un panneau photovoltaïque (1) dans la phase de fonctionnement dudit dispositif (10).

12. Dispositif (10) selon la revendication 11, **caractérisé en ce que** ledit support (23) présente, sur ladite face (28), un siège (30) avec un développement longitudinal, qui est défini par deux parois opposées (29a, 29b) mutuellement parallèles qui sont orthogonales au plan de couchage de ladite face (28), les éléments suivants étant insérés dans ledit siège (30) :
- ledit second segment sensiblement rectiligne (21a, 21b) desdites branches (13a, 13b) dudit filament (12), en contact avec une certaine correspondante desdites parois (29a, 29b), de sorte qu'il est contenu dans l'encombrement dudit support (23) et ne fait pas saillie à partir de ladite face (28),
- ledit insert (14), de sorte qu'il fasse saillie au moins partiellement à partir dudit support (23) au-delà de ladite face (28).

13. Dispositif (10) selon l'une quelconque des revendications précédentes, **caractérisé en ce que** ledit siège (30) du support (23) présente un logement (31) pour ledit insert (14) qui est profilé pour un couplage de même forme à une première partie d'extrémité (32) dudit insert (14) qui est opposée à une seconde partie d'extrémité (33) capable de venir en contact avec un ruban de collecteur (2) d'un panneau photovoltaïque (1), ledit logement (31) étant interposé entre ladite première branche (13a) et ladite seconde branche (13b) dudit filament (12).

14. Dispositif (10) selon l'une quelconque des revendications précédentes, **caractérisé en ce que** ledit insert (14) présente une section sensiblement en forme de T, avec :
- ladite première partie d'extrémité (32), élargie, qui correspond à l'aile de ladite section en forme de T,
- ladite seconde partie d'extrémité (33), qui correspond à la base de l'âme de ladite section en forme de T, qui fait saillie à partir de ladite face (28) dudit support (23).

15. Dispositif (10) selon l'une quelconque des revendications précédentes, **caractérisé en ce qu'**entre ledit insert (14) et lesdites branches (13a, 13b) dudit filament (12), ledit support (23) comprend deux appendices longitudinaux, respectivement :
- un premier appendice longitudinal (34a) entre ladite âme de ladite section en forme de T dudit insert (14) et ledit second segment sensiblement rectiligne (21a) de ladite première branche (13a),
- un second appendice longitudinal (34b) entre ladite âme de ladite section en forme de T dudit insert (14) et ledit second segment sensiblement rectiligne (21b) de ladite seconde branche (13b).
